# EUROPEAN PATENT SPECIFICATION

(11) **EP 4 378 906 B1**
(45) Date of publication and mention of the grant of the patent: **05.03.2025**
(21) Application number: 23168520.7
(22) Date of filing: 18.04.2023
(51) Int. Cl.: C03C 27/10, B09B 3/35, B24B 1/00, B32B 17/06, C03B 33/00

(54) **ARCHITECTURAL GLASS MADE OF WASTE SOLAR PANEL AND MANUFACTURING METHOD THEREOF**
ARCHITEKTONISCHES GLAS AUS ABFALLSOLARPANEEL UND HERSTELLUNGSVERFAHREN DAFÜR
VERRE ARCHITECTURAL FAIT D'UN PANNEAU SOLAIRE USAGÉ ET SON PROCÉDÉ DE FABRICATION

(30) Priority: 01.12.2022 TW 111213308 U
(43) Date of publication of application: 05.06.2024
(73) Proprietor: Transcene Corporation, Danong Vil. (TW)
(72) Inventor: HSIEH, Ya Min, Danong Vil. Liuying Dist. (TW); CHOU, Hsin Hui, Danong Vil. Liuying Dist. (TW); HSIEH, Hsing Wen, Danong Vil. Liuying Dist. (TW); HU, Shao Hua, Danong Vil. Liuying Dist. (TW); CHENG, Min-Jen, Danong Vil. Liuying Dist. (TW); CHEN, Yung-Hui, Danong Vil. Liuying Dist. (TW)
(74) Representative: Brown, Michael Stanley

(56) References cited:
- CN-A- 113 385 520
- DENG RONG ET AL: "Recent progress in silicon photovoltaic module recycling processes", RESOURCES, CONSERVATION AND RECYCLING, ELSEVIER, AMSTERDAM, NL, vol. 187, 24 August 2022 (2022-08-24), XP087185834, ISSN: 0921-3449, [retrieved on 20220824], DOI: 10.1016/J.RESCONREC.2022.106612

## Description

### BACKGROUND OF THE PRESENT INVENTION

### FIELD OF INVENTION

The present invention relates to an architectural glass made of waste solar panel and manufacturing method thereof, in particular to an architectural glass which is completely obtained from waste solar panel, cut and compounded.

### DESCRIPTION OF RELATED ARTS

It is noted that fossil fuels are gradually exhausted due to the continuous development of human beings, so the development of energy is extremely important, and solar power generation has become one of the development priorities of alternative energy in countries around the world. However, with the increase of the number of solar panels used, the number of waste solar panels that need to be treated by countries in the future is also increasing. The International Renewable Energy Agency (IRENA) estimates that the global solar panels will increase from 250000 tons at the end of 2016 to more than 5 million tons in 2050. The composition of the solar panel is to encapsulate the solar cells with sealing materials, such as EVA plastic, between the glass and the back plate, and then install aluminum frames around them. Ninety percent of solar cells on the market are made of silicon crystals. Therefore, the main materials of solar panels are about 75% glass, 10% aluminum, 10% ethylene vinyl acetate (EVA), and others include silicon, copper, silver, etc. Since solar panels contain recyclable and reusable materials, solar waste panels are generally recycled and reused. For example, CN 113 385 520 discloses a method for recycling solar panels. The current treatment of solar waste panels is to disassemble the aluminum frame, junction box, and cables first, then smash the waste solar panels, and then deliver the broken pieces to an incineration plant, export them overseas or reuse them, wherein after the broken glass is ground into "glass sand", it can be mixed with asphalt to pave roads or make high-pressure concrete bricks, which not only has a reflective effect at night, but also has an anti-slip function. It is an environmentally friendly building material. However, it is a pity and a great waste to break the intact glass.

### SUMMARY OF THE PRESENT INVENTION

A main object of the present invention is to provide an architectural glass made of waste solar panel and manufacturing method thereof, which can effectively solve the problem of waste solar panels.

A manufacturing method of architectural glass made of waste solar panel, wherein the steps are as follows:
(1) removing an aluminum frame and taking out a glass plate with the largest area: using laser or diamond to cut the glass with the largest area of a waste solar panel, separating the aluminum frame from the waste solar panel, and taking out the glass plate with the largest area;
(2) removing the non-glass parts, such as the back plate, solar cell and wire, on the glass plate: removing the non-glass parts such as the back plate, solar cell and wire on the glass plate obtained in step (1) with a grinding wheel in order to preserve a complete glass plate;
(3) polishing the surface of the glass plate: polishing the surface of the glass plate obtained in step (2) to restore the bright surface of the glass plate;
(4) processing and cutting the glass plate: cutting the glass plate obtained in step (3) into required sizes; and
(5) compositing the glass plates into architectural glasses: stacking and laminating the glass plates obtained in step (4) in multiple layers to form a composite architectural glass.

The architectural glass made of waste solar panel and manufacturing method thereof, wherein the architectural glass comprises an upper glass plate and a lower glass plate, which are respectively made of glass removed from waste solar panels, an intermediate material arranged between the upper glass plate and the lower glass plate, and a sealant glued and sealed surround the edges of the upper glass plate and the lower glass plate together, wherein the intermediate material is implemented as a heat-insulating paper or heat-insulating paint or decorative sheet, wherein the sealant is selected from the group of adhesive materials consisting of EVA (ethylene vinyl acetate copolymer), PET (polyethylene terephthalate) or resin.

The architectural glass made of waste solar panel and manufacturing method thereof, wherein the architectural glass comprises an upper glass plate and a lower glass plate, which are respectively made of glass removed from waste solar panels, an intermediate material arranged on the bottom surface of the upper glass plate or the top surface of the lower glass plate, and an sealant glued and sealed surround the edges of the upper glass plate and the lower glass plate together, wherein the intermediate material is implemented as a heat-insulating paper or heat-insulating paint or decorative sheet, wherein a space is formed between the upper glass plate and the lower glass plate, wherein the sealant is selected from the group of adhesive materials consisting of EVA (ethylene vinyl acetate copolymer), PET (polyethylene terephthalate) or resin.

The advantages of the architectural glass made from waste solar panels of the present invention include: Through the processing, cutting and compounding of the glass plates in the waste solar panels, the glass plates in the waste solar panels can be made into architectural glasses. Discarded solar glass panels can be reused and can replace tiles, wall decorations, wallpapers, etc., as building materials to beautify indoor and outdoor walls and ceilings. The building material made by the method of the invention enables the glass to be fully reused and can significantly reduce carbon emissions.

### BRIEF DESCRIPTION OF THE DRAWINGS

FIG.1 is a flow diagram of obtaining glass from waste solar panel according to an embodiment of the present invention.
FIG. 2 is an exploded view of an embodiment according to the present invention.
FIG. 3 is a perspective view of the first embodiment according to the present invention.
FIG. 4 is a sectional view of the above first embodiment according to the present invention.
FIG. 5 is a sectional view of the second embodiment according to the present invention.

### DETAILED DESCRIPTION OF THE PREFERRED EMBODIMENT

In order to achieve the above-mentioned objects and effects of the present invention, the technical means adopted are hereby enumerated through a preferred feasible embodiment, and illustrated in the drawings, detailed as follows:

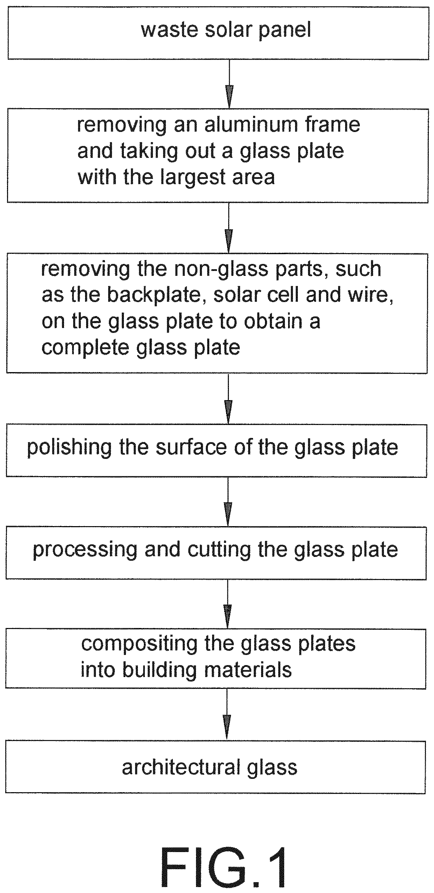

According to an embodiment of the present invention, referring to Fig. 1, the glass part of the waste solar panel is completely taken out to make an architectural glass, and the method is as follows:
(1) removing an aluminum frame and taking out a glass plate with the largest area: using laser or diamond to cut the glass with the largest area of a waste solar panel, separating the aluminum frame from the waste solar panel, and taking out the glass plate with the largest area;
(2) removing the non-glass parts, such as the back plate, solar cell and wire, on the glass plate: removing the non-glass parts such as the back plate, solar cell and wire on the glass plate obtained in step (1) with a grinding wheel in order to preserve a complete glass plate;
(3) polishing the surface of the glass plate: polishing the surface of the glass plate obtained in step (2) to restore the bright surface of the glass plate;
(4) processing and cutting the glass plate: cutting the glass plate obtained in step (3) into required sizes, wherein the cut size is allowed to be standardized, and the cut size is allowed to be 30X30 cm, 30X60 cm, 45X45 cm, etc. ; and
(5) compositing the glass plates into architectural glasses: stacking and laminating the glass plates obtained in step (4) in multiple layers to form a composite building material, which is allowed to be used as the architectural glass.

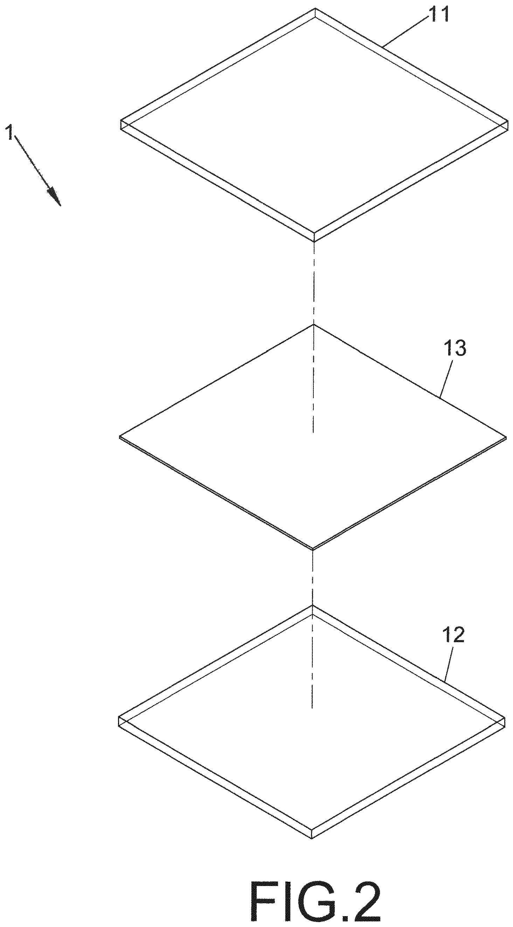

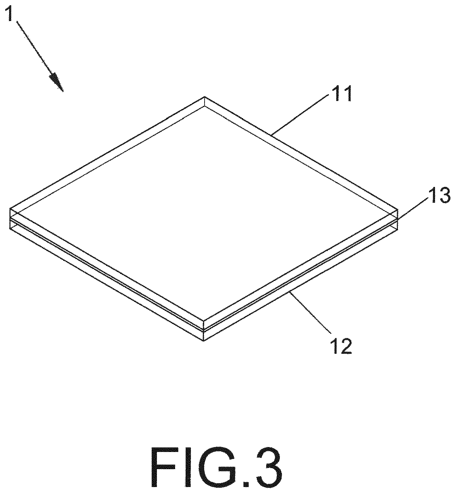

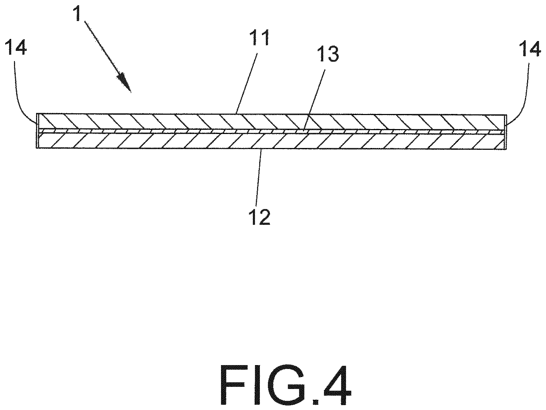

According to the first embodiment of the present invention, as shown in Figs. 2-4, the architectural glass made of the above-mentioned waste solar panels mainly includes an upper glass plate 11, a lower glass plate 12 and an intermediate material 13 arranged thereon, wherein the intermediate material 13 is arranged between the upper glass plate 11 and the lower glass plate 12, and is glued together to form an architectural glass 1, wherein the intermediate material 13 is allowed to be heat-insulating paper or heat-insulating paint or decorative sheet... etc., wherein the architectural glass 1 further includes a sealant 14 seal the periphery thereof, wherein the sealant 14 is allowed to be one of EVA (ethylene vinyl acetate copolymer), PET (polyethylene terephthalate) or resin, etc., to form an architectural glass 1.

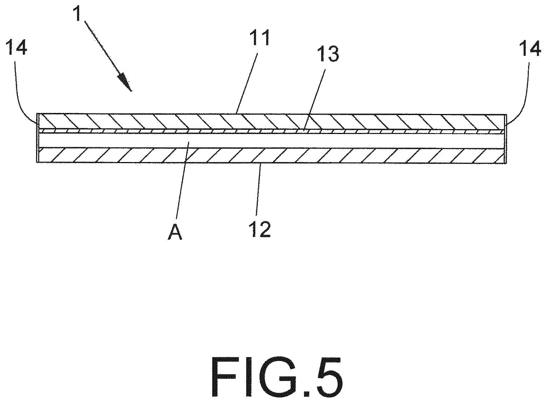

According to the second embodiment of the present invention, as shown in FIG. 5, the above-mentioned waste solar panel is made into an architectural glass, which mainly includes an upper glass plate 11, a lower glass plate 12 and an intermediate material 13 arranged thereon, wherein the intermediate material 13 is allowed to be heat-insulating paper or heat-insulating paint or decorative sheet... etc., wherein the intermediate material 13 is arranged on the bottom surface of the upper glass plate 11, or on the top surface of the lower glass plate 12, wherein a space A is formed between the upper glass plate 11 and the lower glass plate 12, wherein a periphery of the upper glass plate 11 and the lower glass plate 12 are bonded together with a sealant 14 for edge sealing, wherein the sealant 14 is selected from the group of adhesive materials consisting of EVA (ethylene vinyl acetate copolymer), PET (polyethylene terephthalate) or resin, thus forming an architectural glass 1.

According to the present invention, the glass of waste solar panel is used to make a composite architectural glass 1, wherein the intermediate material 13 is allowed to be implemented as a heat insulation layer, which has a heat insulation effect. Moreover, the space A formed between the upper glass plate 11 and the lower glass plate 12, the heat conduction can be greatly reduced, and a better heat insulation effect can be achieved. In addition, the intermediate material 13 is also allowed to be a decorative sheet with designs, patterns or colors, etc., and it is allowed to be manufactured into architectural glass 1 with specifications such as patterns and colors, which can be used for decoration. The architectural glass 1 produced by the present invention can be used as a substitute for tiles, wall tiles, floor tiles, etc., and can be used to beautify walls, floors, ceilings and other architectural decorations. Moreover, the solar panel has excellent strength, and the architectural glass 1 made of the glass of the waste solar panel in the present invention also has the effects of good strength, heat insulation and antifreeze. The architectural glass 1 of the present invention is also allowed to be cut into a smaller size and used as mosaic tiles. The raw material of the building material of the present invention is solar waste panel, which is a green building material (low-carbon building material), and the carbon emission produced by processing is much lower than building materials such as tiles, wallpapers, stainless steel, plastics, etc., and has the advantage of low carbon emission.

In summary, the present invention has indeed achieved the expected objects and effects, and is more ideal and practical than those in the art.

## Claims

1. A manufacturing method of architectural glass made of waste solar panel, comprising the steps of:
(1) removing an aluminum frame and taking out a glass plate with the largest area: using laser or diamond to cut the glass with the largest area of a waste solar panel, separating the aluminum frame from the waste solar panel, and taking out the glass plate with the largest area;
(2) removing the non-glass parts, such as the back plate, solar cell and wire, on the glass plate: removing the non-glass parts such as the back plate, solar cell and wire on the glass plate obtained in step (1) with a grinding wheel to preserve a complete glass plate;
(3) polishing the surface of the glass plate: polishing the surface of the glass plate obtained in step (2) to restore the bright surface of the glass plate;
(4) processing and cutting the glass plate: cutting the glass plate obtained in step (3) into required sizes; and
(5) compositing the glass plates into architectural glasses: stacking and laminating the glass plates obtained in step (4) in multiple layers to form a composite architectural glass.

2. The manufacturing method of architectural glass made of waste solar panel, as recited in claim 1, wherein the architectural glass 1 comprises an upper glass plate 11 and a lower glass plate 12, which are respectively made of glass removed from waste solar panels, an intermediate material 13 arranged between the upper glass plate 11 and the lower glass plate 12, and a sealant 14 glued and sealed surround the edges of the upper glass plate 11 and the lower glass plate 12 together, wherein the intermediate material 13 is implemented as a heat-insulating paper or heat-insulating paint or decorative sheet, wherein the sealant 14 is selected from the group of adhesive materials consisting of EVA (ethylene vinyl acetate copolymer), PET (polyethylene terephthalate) or resin.

3. The manufacturing method of architectural glass made of waste solar panel, as recited in claim 1, wherein the architectural glass 1 comprises an upper glass plate 11 and a lower glass plate 12, which are respectively made of glass removed from waste solar panels, an intermediate material 13 arranged on the bottom surface of the upper glass plate 11 or the top surface of the lower glass plate 12, and a sealant 14 glued and sealed surround the edges of the upper glass plate 11 and the lower glass plate 12 together, wherein the intermediate material 13 is implemented as a heat-insulating paper or heat-insulating paint or decorative sheet, wherein a space A is formed between the upper glass plate 11 and the lower glass plate 12, wherein the sealant is selected from the group of adhesive materials consisting of EVA (ethylene vinyl acetate copolymer), PET (polyethylene terephthalate) or resin.

## Patentansprüche

1. Herstellungsverfahren von Architekturglas aus Abfall-Solarpaneel, umfassend die Schritte:
(1) Entfernen eines Aluminiumrahmens und Entnehmen einer Glasplatte mit der größten Fläche: Verwenden von Laser oder Diamant zum Schneiden des Glases mit der größten Fläche eines Abfall-Solarpaneels, Trennen des Aluminiumrahmens von dem Abfall-Solarpaneel und Entnehmen der Glasplatte mit der größten Fläche;
(2) Entfernen der Nichtglas-Teile, wie z.B. der Rückplatte, Solarzelle und Draht, auf der Glasplatte: Entfernen der Nichtglas-Teile, wie z.B. der Rückplatte, Solarzelle und Draht, auf der bei Schritt (1) erhaltenen Glasplatte mit einer Schleifscheibe, um eine vollständige Glasplatte zu bewahren;
(3) Polieren der Oberfläche der Glasplatte: Polieren der Oberfläche der bei Schritt (2) erhaltenen Glasplatte, um die helle Oberfläche der Glasplatte wiederherzustellen;
(4) Verarbeiten und Schneiden der Glasplatte: Schneiden der bei Schritt (3) erhaltenen Glasplatte zu erforderlichen Größen; und
(5) Zusammensetzen der Glasplatten zu Architekturgläsern: Stapeln und Laminieren der bei Schritt (4) erhaltenen Glasplatten in mehreren Schichten, um ein Verbund-Architekturglas zu bilden.

2. Herstellungsverfahren von Architekturglas aus Abfall-Solarpaneelen nach Anspruch 1, wobei das Architekturglas 1 eine obere Glasplatte 11 und eine untere Glasplatte 12, die jeweils aus Glas, das aus Abfall-Solarpaneelen entfernt ist, hergestellt sind, ein Zwischenmaterial 13, das zwischen der oberen Glasplatte 11 und der unteren Glasplatte 12 angeordnet ist, und ein Dichtmittel 14, das die Ränder der oberen Glasplatte 11 und der unteren Glasplatte 12 zusammenklebt und dichtend umgibt, umfasst, wobei das Zwischenmaterial 13 als ein wärmeisolierendes Papier oder wärmeisolierende Lack- oder Dekorfolie ausgeführt ist, wobei das Dichtmittel 14 ausgewählt ist aus der Gruppe von Klebematerialien bestehend aus EVA (Ethylen-Vinylacetat-Copolymer), PET (Polyethylenterephthalat) und Harz.

3. Herstellungsverfahren von Architekturglas aus Abfall-Solarpaneelen nach Anspruch 1, wobei das Architekturglas 1 eine obere Glasplatte 11 und eine untere Glasplatte 12, die jeweils aus Glas, das aus Abfall-Solarpaneelen entfernt ist, hergestellt sind, ein Zwischenmaterial 13, das auf der unteren Oberfläche der oberen Glasplatte 11 oder der oberen Oberfläche der unteren Glasplatte 12 angeordnet ist, und ein Dichtmittel 14, das die Ränder der oberen Glasplatte 11 und der unteren Glasplatte 12 zusammenklebt und dichtend umgibt, umfasst, wobei das Zwischenmaterial 13 als ein wärmeisolierendes Papier oder wärmeisolierende Lack- oder Dekorfolie ausgeführt ist, wobei zwischen der oberen Glasplatte 11 und der unteren Glasplatte 12 ein Raum A gebildet ist, wobei das Dichtmittel ausgewählt ist aus der Gruppe der Klebematerialien bestehend aus EVA (Ethylen-Vinylacetat-Copolymer), PET (Polyethylenterephthalat) und Harz.

## Revendications

1. Procédé de fabrication de verre architectural constitué de panneaux solaires usagés, comprenant les étapes suivantes :
(1) retrait d'un cadre d'aluminium et extraction d'une plaque de verre avec la plus grande superficie : au moyen d'un laser ou d'un diamant pour découper le verre avec la plus grande superficie d'un panneau solaire usagé, la séparation du cadre d'aluminium du panneau solaire usagé, et l'extraction de la plaque de verre avec la plus grande superficie ;
(2) retrait des parties qui ne sont pas en verre, telles que la plaque arrière, les cellules solaires et les fils, sur la plaque de verre : le retrait des parties qui ne sont pas en verre telles que la plaque arrière, les cellules solaires et les fils sur la plaque de verre obtenue à l'étape (1) avec une meule pour conserver une plaque de verre complète ;
(3) polissage de la surface de la plaque de verre : le polissage de la surface de la plaque de verre obtenue à l'étape (2) pour restaurer la surface brillante de la plaque de verre ;
(4) traitement et découpe de la plaque de verre : la découpe de la plaque de verre obtenue à l'étape (3) dans des tailles requises ; et
(5) composition des plaques de verre en verres architecturaux : l'empilement et la stratification des plaques de verre obtenues à l'étape (4) en multiples couches pour former un verre architectural composite.

2. Procédé de fabrication de verre architectural constitué de panneaux solaires usagés selon la revendication 1, dans lequel le verre architectural 1 comprend une plaque de verre supérieure 11 et une plaque de verre inférieure 12, qui sont respectivement constituées de verre retiré de panneaux solaires usagés, un matériau intermédiaire 13 disposé entre la plaque de verre supérieure 11 et la plaque de verre inférieure 12, et un produit d'étanchéité 14 collé et scellé autour des bords de la plaque de verre supérieure 11 et de la plaque de verre inférieure 12 maintenues ensemble, dans lequel le matériau intermédiaire 13 est mis en œuvre sous la forme d'un papier thermiquement isolant, ou d'une peinture thermiquement isolante, ou d'une feuille décorative, dans lequel le produit d'étanchéité 14 est choisi dans le groupe de matériaux adhésifs constitué par l'EVA (copolymère éthylène-acétate de vinyle), le PET (téréphtalate de polyéthylène) et une résine.

3. Procédé de fabrication de verre architectural constitué de panneaux solaires usagés selon la revendication 1, dans lequel le verre architectural 1 comprend une plaque de verre supérieure 11 et une plaque de verre inférieure 12, qui sont respectivement constituées de verre retiré de panneaux solaires usagés, un matériau intermédiaire 13 disposé sur la surface inférieure de la plaque de verre supérieure 11 ou la surface supérieure de la plaque de verre inférieure 12, et un produit d'étanchéité 14 collé et scellé autour des bords de la plaque de verre supérieure 11 et de la plaque de verre inférieure 12 maintenues ensemble, dans lequel le matériau intermédiaire 13 est mis en œuvre sous la forme d'un papier thermiquement isolant, ou d'une peinture thermiquement isolante, ou d'une feuille décorative, dans lequel un espace A est formé entre la plaque de verre supérieure 11 et la plaque de verre inférieure 12, dans lequel le produit d'étanchéité est choisi dans le groupe de matériaux adhésifs constitué par l'EVA (copolymère éthylène-acétate de vinyle), le PET (téréphtalate de polyéthylène) et une résine.
